# EUROPÄISCHE PATENTSCHRIFT

(11) **EP 3 427 345 B1**
(45) Veröffentlichungstag und Bekanntmachung des Hinweises auf die Patenterteilung: **19.08.2020**
(21) Anmeldenummer: 17715895.3
(22) Anmeldetag: 01.03.2017
(51) Int. Cl.: H01R 13/514, G01R 33/07, G01R 15/20, H01R 13/66

(54) **STROMMESSUNG IM ISOLIERKÖRPER**
CURRENT MEASUREMENT IN THE INSULATING BODY
MESURE DU COURANT DANS UN CORPS ISOLANT

(30) Priorität: 09.03.2016 DE 102016104267
(43) Veröffentlichungstag der Anmeldung: 16.01.2019
(73) Patentinhaber: Harting Electric GmbH & Co. KG, 32339 Espelkamp (DE)
(72) Erfinder: KROPIEWNICKI, Norbert, 33619 Bielefeld (DE)
(86) Internationale Anmeldenummer: PCT/DE2017/100162
(87) Internationale Veröffentlichungsnummer: WO 2017/152908

(56) Entgegenhaltungen:
- EP-A1- 2 782 195
- WO-A2-2015/149757
- DE-A1-102006 006 314
- DE-U1-202007 018 306
- US-A1- 2010 112 866
- US-A1- 2012 217 964
- US-B1- 6 472 878

## Beschreibung

### Beschreibung

Die Erfindung geht aus von einem Isolierkörper für einen Steckverbinder nach dem Oberbegriff des unabhängigen Anspruchs 1.

Derartige Isolierkörper werden beispielsweise in Steckverbindergehäuse eingesetzt. In modularen Industriesteckverbinder werden derartige Isolierkörper, in der Regel mit weiteren verschiedenartigen Isolierkörpern, in so genannte Halterahmen eingesetzt und anschließend in ein Steckverbindergehäuse eingebaut. Dann werden die Isolierkörper auch Module genannt.

### Stand der Technik

Die US 2012/02179664 A1 zeigt eine Strommesseinrichtung. Die Strommesseinrichtung hat einen Eingang in Form einer Buchse. In die Buchse kann ein Steckverbinder eines elektrischen Geräts eingesteckt werden. Die Strommesseinrichtung hat weiterhin einen Ausgang in Form eines Steckverbinders, der analog zum Steckverbinders des elektrischen Geräts ausgebildet ist und der zum Anschluss des Systems aus elektrischem Gerät und Strommesseinrichtung dient.

Die US 2010/0112866 A1 zeigt eine Strommesseinrichtung, die zwischen einem Steckverbinder und einer zugehörigen Buchse angeordnet ist.

Die EP 2 782 195 A1 zeigt einen einpoligen Steckverbinder mit integriertem Stromsensor.

Die DE 10 2006 006 314 A1 eine in eine Gerätebuchse integrierte Strommesseinrichtung, die beispielsweise bei Hybridfahrzeugen eingesetzt wird.

Die US 6,472,878 B1 zeigt einen Strommesssensor. Die DE 20 2077 018 306 U1 zeigt ein Steckverbindermodul, welches eine Mess- und Auswertefunktion umfasst und bspw. einen Stromsensor aufweist.

Die WO 2015/149757 A2 zeigt einen Halterahmen in welchen einzelne Isolierkörper mit Sensoren, so genannte Module, einsetzbar sind. Aufgrund der erforderlichen kompakten Bauweise der Isolierkörper ist es schwierig Sensoren innerhalb der Isolierkörper zu positionieren.

### Aufgabenstellung

Die Aufgabe der Erfindung besteht darin, einen kompakten und gleichzeitig kostengünstigen Isolierkörper zu generieren, bei dem die durch die einzelnen Kontaktelemente fließenden Ströme monitorbar sind.

Die Aufgabe wird durch die kennzeichnenden Merkmale des unabhängigen Anspruchs 1 gelöst.

Vorteilhafte Ausgestaltungen der Erfindung sind in den Unteransprüchen angegeben.

Der erfindungsgemäße Isolierkörper ist für einen Steckverbinder vorgesehen. Der Isolierkörper kann direkt in ein Steckverbindergehäuse eingebaut werden. In der Regel wird der Isolierkörper jedoch als Modul in einem modularen Industriesteckverbinder eingesetzt. Dazu werden mehrere verschiedenartige Module in einem Gelenkrahmen zusammengesetzt, wie er beispielsweise in der WO 2014/202050 A1 gezeigt ist.

In dem Isolierkörper sind zumindest zwei elektrische Kontaktelemente angeordnet. Mit "elektrisch" ist in diesem Fall gemeint, dass über die Kontaktelemente ein elektrischer Strom fließen kann, wenn der Steckverbinder mit einem Gegenstecker oder in eine Buchse gesteckt ist. Der erfindungsgemäße Isolierkörper weist zumindest zwei Sensoren zur Strommessung auf, wobei jeder Sensor einem elektrischen Kontaktelement zugeordnet ist. Die Anzahl der Sensoren entspricht der Anzahl der im Isolierkörper vorhandenen elektrischen Kontaktelemente. Jeder Sensor ist genau einem elektrischen Kontaktelement zugeordnet. Es können weitere nicht elektrische Kontaktelemente, beispielsweise pneumatische Kontaktelemente, vorhanden sein, denen kein Sensor zugeordnet ist.

Der Isolierkörper besteht aus einem aus Kunststoff bestehenden Grundkörper und zwei Seitenteilen, einem ersten Seitenteil und einem zweiten Seitenteil. Beide Seitenteile sind aus einem Kunststoff gefertigt, wobei das erste Seitenteil einen metallischen Kern beinhaltet. Derartige Komponenten sind preisgünstig herstellbar.

Zumindest zwei Schirmarme stehen vom dem ersten Seitenteil senkrecht ab. Die Schirmarme sind durch Ausnehmungen im Grundkörper hindurch geführt. Der metallische Kern ist in den Schirmarmen angeordnet. Vorzugsweise stehen vom ersten Seitenteil zumindest vier Schirmarme senkrecht ab, wobei jeweils zwei Schirmarme zu einem Schirmarmpaar zusammengefasst sind. Zwischen die Enden der Schirmarmpaare greift jeweils ein dafür vorgesehener Steg des zweiten Seitenteils ein, wodurch eine verkeilende Wirkung entsteht.

Der Isolierkörper weist vorzugsweise eine Leiterplatte auf. Die Leiterplatte weist Ausnehmungen auf. Die Schirmarme beziehungsweise die Schirmarmpaare des ersten Seitenteils greifen jeweils durch eine Ausnehmungen der Leiterplatte hindurch. Durch die oben beschriebene verkeilende Wirkung, von den Schirmarmpaaren und den zugeordneten Stegen, wird die Leiterplatte parallel zu den Seitenteilen und dem Grundkörper ausgerichtet. Die Seitenteile weisen an den Schmalseiten jeweils Rastnasen auf, die in dafür vorgesehene Rastausnehmungen des Grundkörpers einrasten können. Dadurch wird eine besonders einfache Montage des Isolierkörpers ermöglicht.

Besonders vorteilhaft ist es die Sensoren auf der Leiterkarte zu montieren. Die Leiterkarte kann dann auch eine Auswerteelektronik umfassen. Die Sensoren sind durch die Schirmarme elektromagnetisch voneinander abgeschirmt. Jeder Sensor ist einem elektrischen Kontaktelement zugeordnet und kann ungestört vom benachbarten Sensor Strommessungen durchführen.

Die Leiterplatte weist so genannte Ausgänge auf, über die die gemessenen Daten abgerufen bzw. abgegriffen werden können. Vorzugsweise handelt es sich bei den zumindest zwei Sensoren jeweils um einen Hall-Sensor. Derartige Sensoren liefern auch Messwerte bei einem konstanten Stromfluss im Gegensatz zu Sensoren die Spulen enthalten.

Es ist besonders vorteilhaft, wenn am Isolierkörpers Stege angeformt sind, mit denen der Isolierkörper in einen Halterahmen eines Industriesteckverbinders befestigbar ist. Dadurch kann der Isolierkörper mit weiteren verschiedenen Modulen in einen modularen Industriesteckverbinder integriert werden.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Explosionszeichnung eines erfindungsgemäßen Isolierkörpers,
- Fig. 2: eine perspektivische Darstellung eines ersten Seitenteils,
- Fig. 3: eine perspektivische Darstellung eines Grundkörpers,

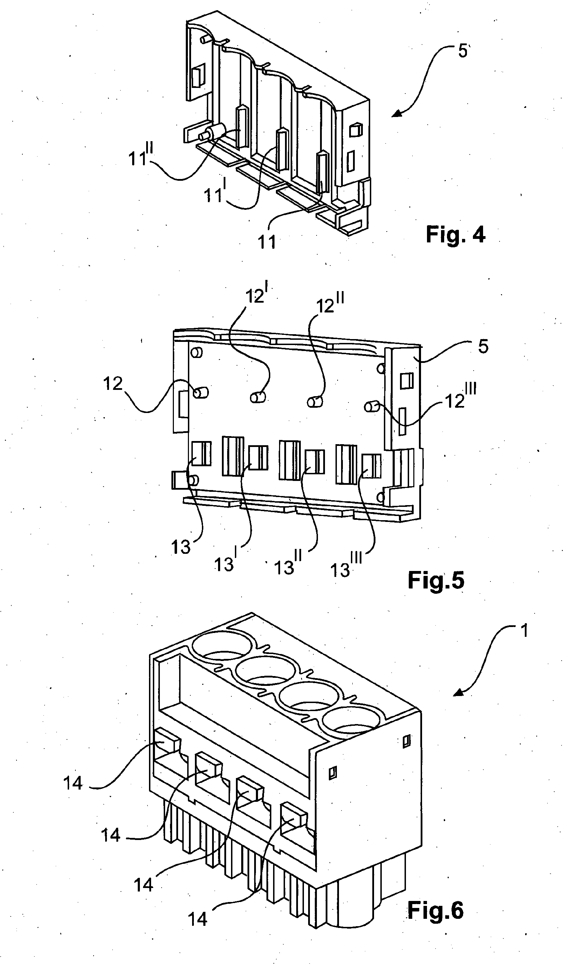

- Fig. 4: eine perspektivische Darstellung eines zweiten Seitenteils,
- Fig. 5: eine perspektivische Darstellung des zweiten Seitenteils mit einer eingefügten Leiterplatte,
- Fig. 6: eine perspektivische Darstellung des Isolierkörpers,
- Fig. 7: eine Draufsicht auf die Leiterplatte und das zweite Seitenteil und
- Fig. 8: eine perspektivische Darstellung des ersten Seitenteils mit integrierten Schirmblechen, wobei das erste Seitenteil transparent dargestellt ist.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

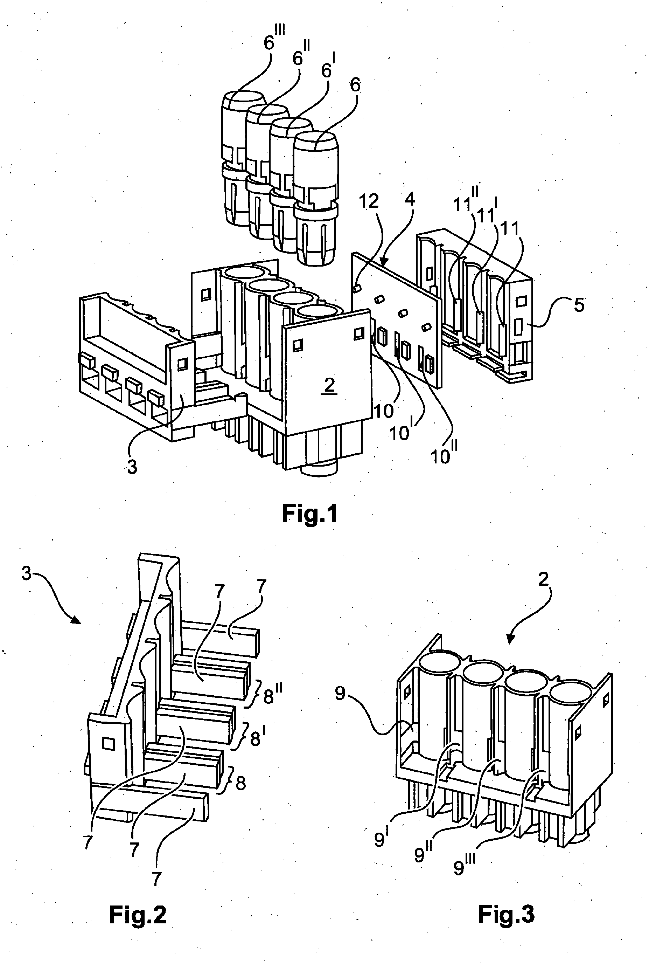

Die Figur 1 zeigt eine Explosionszeichnung des erfindungsgemäßen Isolierkörpers 1. Der Isolierkörper 1 besteht im Wesentlichen aus einem aus Kunststoff bestehenden Grundkörper 2, einem ersten Seitenteil 3, einer Leiterkarte 4 und einem zweiten Seitenteil 5. Im Grundkörper 2 sind elektrische Kontaktelemente 6, 6', 6", 6'" angeordnet.

Das erste Seitenteil ist im Wesentlichen aus Kunststoff gebildet. Vom ersten Seitenteil 3 stehen Schirmarme 7 ab. Innerhalb der Schirmarme 7 sind U-förmige Schirmbleche 18 eingebracht. Die Kunststoffform des ersten Seitenteils 3 hat dafür hole Schirmarmformen, die hinten zum Hineinschieben der Schirmbleche 18 offen sind. Die Schirmarme haben demnach einen metallischen Kern. In diesem Ausführungsbeispiel werden die Schirmbleche 18 in das erste Seitenteil 3 eingeschoben. Das Einbringen der Schirmbleche durch Umspritzung ist aber ebenfalls denkbar.

Aus Figur 2 ist zu entnehmen, dass vom ersten Seitenteil 3 endseitig zwei Schirmarme 7 abstehen. Zwischen den endseitigen Schirmarmen 7 sind drei Schirmarmpaare 8 angeordnet, wobei jedes Schirmarmpaar 8 aus jeweils zwei einzelnen Schirmarmen 7 gebildet ist.

Die Schirmarme 7 und Schirmarmpaare 8 können durch Ausnehmungen 9 im Grundkörper 2 und durch Ausnehmungen 10 in der Leiterplatte 4 auf das zweite Seitenteil 5 durchgreifen. Zwischen die Enden der Schirmarmpaare 8 gleitet ein Steg, wodurch die Schirmarme 7 der Schirmarmpaare 8 nach außen gedrückt und eine verkeilende Wirkung entfaltet wird. Durch die nach außen gedrückten Schirmarme 7 der Schirmarmpaare 8 wird die Leiterplatte 4 passgenau ausgerichtet. Durch diese passgenaue Ausrichtung kann die Leiterplatte 4 in ihre vorgesehene Position innerhalb des zweiten Seitenteils 5 gleiten. Es ist wichtig, dass die Leiterplatte aufgrund ihrer Funktionsgeometrie in eine definierte Position bzw. Lage zu den Kontaktelementen 6 geführt und arretiert wird. Hierdurch kann sichergestellt werden, dass die Messtechnik zuverlässige Werte liefert und keine Messfehler entstehen. Durch den hier gezeigten Aufbau ist gewährleistet, dass auch nach einer mechanischen Belastung die Positionierung der Leiterplatte 4 bzw. der darauf aufgebrachten Sensoren 13 zu den Kontaktelementen 6 weiterhin bestehen bleibt.

Beim Zusammengleiten von Leiterplatte 4 und zweitem Seitenteil 5 greifen die Zapfen 15 in den Eckpositionen des zweiten Seitenteils 5 in die zugehörigen Aufnahmeöffnungen 16 der Leiterplatte 4 ein. Liegt die Leiterplatte 4 auf der Innenseite des zweiten Seitenteils 5 auf, rastet die Leiterplatte 4 hinter Rastarmen 17 ein.

Im ausgerichteten Zustand können auf der Leiterplatte Federkontakte 12 zum Spannungsabgriff auf die Kontaktelemente 6 aufgreifen. Die Federkontakte 12 und die zugeordneten elektrischen Kontaktelemente 6 befinden sich dann in einem elektrisch leitenden Kontakt zueinander.

Mit der Spannungsinformation und der Strommessung kann die elektrische Energie angegeben werden. Hierfür muss die Leiterplatte samt der Sensorik 13 und den Kontaktelementen 6 in eine vordefinierte Position ausgerichtet bzw. gebracht werden.

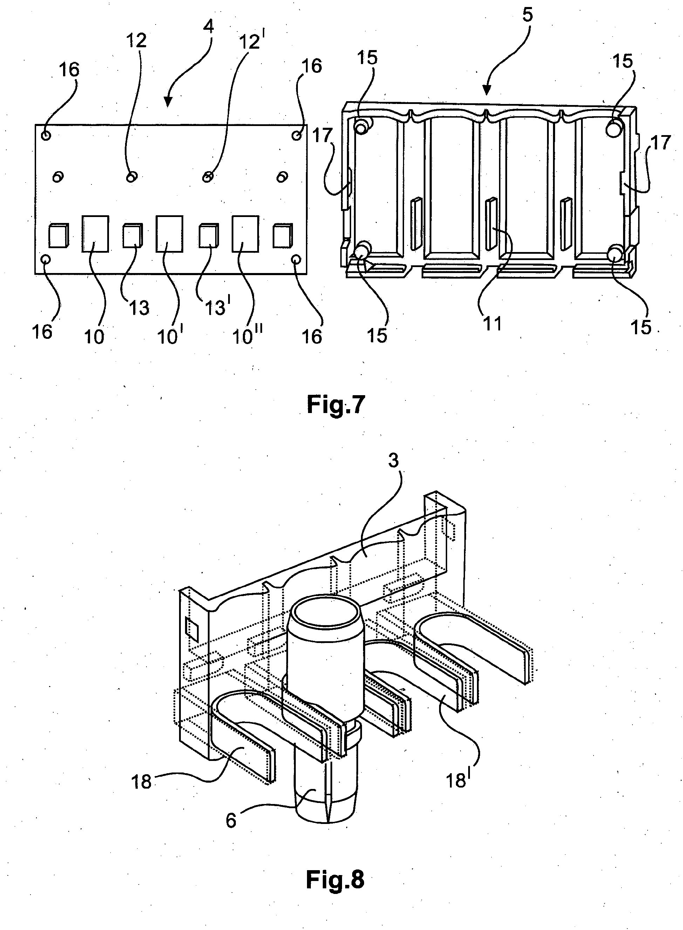

Beim Kern der Schirmarme 7 handelt es sich um weichmagnetische Bleche. Die weichmagnetischen Bleche haben keinen elektrischen Kontakt zu den jeweiligen Kontaktelementen 6. Der metallische Kern der Schirmarme 7 dient zur Abschirmung des am Kontaktelement entstehenden Magnetfelds zum Magnetfeld eines benachbarten Kontaktelements. Hierdurch werden für den Hall-Sensor verschiedene Messbereiche zur Strommessung geschaffen. Außerdem werden die zu messenden Magnetfelder verstärkt. Die Schirmbleche 18 bzw. Schirmarme 7 haben hier auch noch eine Doppelfunktion. Wie Figur 8 zu entnehmen ist können durch die Schirmarme die einzelnen Kontaktelemente 6 im Isolierkörper 1 arretiert werden.

Auf der Leiterplatte 4 befinden sich vier Hall-Sensoren 13, die den jeweiligen Kontaktelementen 6 zugeordnet sind.

Der Abgriff der gemessenen Stromwerte bzw. deren Daten kann unterschiedlich erfolgen und wird nicht näher erläutert.

Am Isolierkörper 1 sind beidseitig Stege 14 angeformt mit denen der Isolierkörper in einen Halterahmen (nicht gezeigt) eines Industriesteckverbinders (nicht gezeigt) fixierbar ist. Die Stege sind außen an den Seitenteilen 3, 5 des Isolierkörpers angeformt.

Die Erfindung betrifft einen Isolierkörper bzw. ein Modul für einen modularen Industriesteckverbinder. In dem Modul sind zumindest zwei elektrische Kontaktelemente 6 angeordnet, denen jeweils ein Hall-Sensor 13 zur Strommessung zugeordnet ist. Die Hall-Sensoren 13 werden innerhalb des Moduls durch Schirmarme 7 elektromagnetisch gegeneinander abgeschirmt.

### Strommessung im Isolierkörper

**Bezugszeichenliste**

| | | | |
|---|---|---|---|
| 1 | Isolierkörper | 11 | Steg |
| 2 | Grundkörper | 12 | Federkontakt |
| 3 | Erstes Seitenteil | 13 | Hall-Sensor |
| 4 | Leiterplatte | 14 | Steg |
| 5 | Zweites Seitenteil | 15 | Zapfen |
| 6 | Elektrisches Kontaktelement | 16 | Aufnahmeöffnung |
| 7 | Schirmarm | 17 | Rastarme |
| 8 | Schirmarmpaar | 18 | Schirmblech |
| 9 | Ausnehmung | | |
| 10 | Ausnehmung | | |

## Patentansprüche

1. Isolierkörper für einen Steckverbinder, wobei der Isolierkörper (1) zumindest zwei elektrische Kontaktelemente (6) aufweist,
wobei der Isolierkörper (1) zumindest zwei Sensoren (13) zur Strommessung aufweist, wobei jeder Sensor (13) einem elektrischen Kontaktelement (6) zugeordnet ist,
wobei der Isolierkörper (1) aus einem aus Kunststoff bestehenden Grundkörper (2) und zwei Seitenteilen, einem ersten Seitenteil (3) und einem zweiten Seitenteil (5), besteht;
**dadurch gekennzeichnet,**
**dass** vom ersten Seitenteil (3) zumindest zwei Schirmarme (7) senkrecht abstehen, die durch Ausnehmungen (9) im Grundkörper (2) hindurchgreifen und
**dass** die Schirmarme einen metallischen Kern haben und dass die Sensoren (13) durch die Schirmarme (7) elektromagnetisch voneinander abgeschirmt sind.

2. Isolierkörper nach Anspruch 1
**dadurch gekennzeichnet,**
- **dass** vom ersten Seitenteil (3) zumindest vier Schirmarme (7) senkrecht abstehen,
- **dass** jeweils zwei Schirmarme (7) zu einem Schirmarmpaar (8) zusammengefasst sind
- **dass** die Schirmarmpaare (8) durch die Ausnehmungen (9) im Grundkörper (2) auf Stege (11) des zweiten Seitenteils (5) eingreifen.

3. Isolierkörper nach einem der vorstehenden Ansprüche
**dadurch gekennzeichnet, dass**
der Isolierkörper (1) eine Leiterplatte (4) aufweist.

4. Isolierkörper nach vorstehendem Anspruch
**dadurch gekennzeichnet,**
- **dass** die Leiterplatte (4) Ausnehmungen (10) aufweist und
- **dass** die Schirmarme (7) und/oder Schirmarmpaare (8) des ersten Seitenteils jeweils durch eine Ausnehmung (10) der Leiterplatte (4) hindurchgreifen.

5. Isolierkörper nach einem der vorstehenden Ansprüche
**dadurch gekennzeichnet,**
**dass** es sich bei den zumindest zwei Sensoren (13) jeweils um einen Hall-Sensor handelt.

6. Isolierkörper nach einem der vorstehenden Ansprüche 3 - 5
**dadurch gekennzeichnet, dass**
die Sensoren (13) auf der Leiterplatte (4) montiert ist/sind.

7. Isolierkörper nach einem der vorstehenden Ansprüche 3 - 6
**dadurch gekennzeichnet, dass**
die Leiterplatte (4) parallel zu den elektrischen Kontaktelementen (6) ausgerichtet ist.

8. Isolierkörper nach einem der vorstehenden Ansprüche
**dadurch gekennzeichnet, dass**
am Isolierkörper (1) zumindest ein Steg (14) angeformt ist, mit denen der Isolierkörper (1) in einen Halterahmen eines Industriesteckverbinders befestigbar ist.

## Claims

1. An insulating body for a plug connector, wherein the insulating body (1) comprises at least two electrical contact elements (6),
**wherein**
the insulating body (1) comprises at least two sensors (13) for measuring the current, wherein each sensor (13) is allocated to an electrical contact element (6),
**wherein**
the insulating body (1) is formed from a synthetic material base body (2) and two lateral parts, a first lateral part (3) and a second lateral part (5) **characterized in that** at least two shield arms (7) protrude in a perpendicular manner from the first lateral part (3), said shield arms engaging through cut-outs (9) in the base body (2)and
that the shield arms have a metal core and
that the sensors (13) are shielded from one another in an electromagnetic manner by means of the shield arms (7)

2. The insulating body as claimed in the preceding claim,
**characterized in**
**that** at least four shield arms (7) protrude in a perpendicular manner from the first lateral part (3),
**that** in each case two shield arms (7) are combined together to form a shield arm pair (8),
**that** the shield arm pairs (8) engage with the connecting pieces (11) of the second lateral part (5) through the cut-outs (9) in the base body (2).

3. The insulating body as claimed in any one of the preceding claims,
**characterized in that**
the insulating body (1) comprises a circuit board (4).

4. The insulating body as claimed in the preceding claim
**characterized in**
**that** the circuit board (4) comprises cut-outs (10) and
**that** the shield arms (7) and/or the shield arm pairs (8) of the first lateral part in each case engage through a cut-out (10) of the circuit board (4).

5. The insulating body as claimed in any one of the preceding claims,
**characterized in**
**that** the at least two sensors (13) are each a Hall sensor.

6. The insulating body as claimed in any one of the preceding claims 3-5,
**characterized in that**
the sensors (13) is/are mounted on the circuit board (4).

7. The insulating body as claimed in any one of the preceding claims 3-6,
**characterized in that**
the circuit board (4) is aligned parallel to the electrical contact elements (6).

8. The insulating body as claimed in any one of the preceding claims,
**characterized in that**
the insulating body (1) is provided with at least one connecting piece (14) as an integral part, with which it is possible to fasten the insulating body (1) in a holding frame of an industrial plug connector.

## Revendications

1. Corps isolant destiné à un connecteur, dans lequel le corps isolant (1) comporte au moins deux éléments de contact électriques (6),
dans lequel le corps isolant (1) comporte au moins deux capteurs (13) pour la mesure de courant, dans lequel chaque capteur (13) est associé à un élément de contact électrique (6),
dans lequel le corps isolant (1) est constitué d'un corps de base (2) en matière plastique et de deux parties latérales, à savoir une première partie latérale (3) et une deuxième partie latérale (5) ;
**caractérisé en ce qu'**au moins deux bras de blindage (7) dépassent verticalement de la première partie latérale (3) et s'engagent à travers des évidements (9) ménagés dans le corps de base (2) et
**en ce que** les bras de blindage ont un noyau métallique et
**en ce que** les capteurs (13) sont blindés électromagnétiquement les uns vis-à-vis des autres par les bras de blindage (7).

2. Corps isolant selon la revendication 1, **caractérisé**
- **en ce qu'**au moins quatre bras de blindage (7) dépassent verticalement de la première partie latérale (3),
- **en ce que** deux bras de blindage (7) sont respectivement combinés pour former une paire de bras de blindage (8),
- **en ce que** les paires de bras de blindage (8) s'engagent à travers les évidements (9) ménagés dans le corps de base (2) sur des nervures (11) de la deuxième partie latérale (5).

3. Corps isolant selon l'une des revendications précédentes, **caractérisé en ce que** le corps isolant (1) comporte une carte de circuit imprimé (4).

4. Corps isolant selon la revendication précédente, **caractérisé**
- **en ce que** la carte de circuit imprimé (4) comporte des évidements (10) et
- **en ce que** les bras de blindage (7) et/ou les paires de bras de blindage (8) de la première partie latérale s'engagent respectivement à travers un évidement (10) de la carte de circuit imprimé (4).

5. Corps isolant selon l'une des revendications précédentes, **caractérisé en ce que** lesdits au moins deux capteurs (13) sont respectivement un capteur Hall.

6. Corps isolant selon l'une des revendications 3 - 5 précédentes, **caractérisé en ce que** les capteurs (13) sont montés sur la carte de circuit imprimé (4).

7. Corps isolant selon l'une des revendications 3 - 6 précédentes, **caractérisé en ce que** la carte de circuit imprimé (4) est orientée parallèlement aux éléments de contact électriques (6).

8. Corps isolant selon l'une des revendications précédentes,
**caractérisé en ce que**, sur le corps isolant (1), est formée au moins une nervure (14) au moyen de laquelle le corps isolant (1) peut être fixé dans un châssis de maintien d'un connecteur industriel.
